# EUROPÄISCHE PATENTSCHRIFT

(11) **EP 2 197 114 B1**
(45) Veröffentlichungstag und Bekanntmachung des Hinweises auf die Patenterteilung: **30.04.2014**
(21) Anmeldenummer: 08020984.4
(22) Anmeldetag: 03.12.2008
(51) Int. Cl.: G01S 7/527, G01S 7/539, G01S 15/88, G06M 1/10, G06M 7/04, H03K 17/94

(54) **Ultraschallsensor mit mehreren Schaltausgängen**
Ultrasound sensor with multiple switch exits
Capteur à ultrasons doté de plusieurs sorties de commutation

(43) Veröffentlichungstag der Anmeldung: 16.06.2010
(73) Patentinhaber: Pepperl + Fuchs GmbH, 68307 Mannheim (DE)
(72) Erfinder: Luber, Ernst, 92259 Neukirchen (DE); Sertl, Claudia, 92259 Neukirchen (DE)
(74) Vertreter: Schiffer, Axel Martin

(56) Entgegenhaltungen:
- EP-A- 0 113 512
- EP-A- 0 525 858
- DE-A1- 19 831 978
- US-A- 5 761 155

## Beschreibung

Bekanntlich emittieren kompakte Näherungsschalter auf Ultraschallbasis zyklisch Schallbündel, auch Sendebursts genannt. Die Echos, welche von den im Bereich eines Schallbündels befindlichen Gegenstände zurückgeworfenen werden, werden von dem Näherungsschalter wieder erfasst und mit einer integrierten Filterstufe durch Anwendung eines Filterkriteriums analysiert. Hierzu werden die emittierten Schallbündel und reflektierten Echos Laufzeitmessungen unterzogen. Dabei sind die Laufzeiten der reflektierten Echosignale in der Regel direkt proportional zum Abstand der Gegenstände vom Näherungsschalter.

Es ist damit möglich, das Vorhandensein bzw. Fehlen eines Objektes im Bereich des Schallbündels zu detektieren und in Form eines binären Signals an einem Schaltausgang zu signalisieren. Kann das jeweilige Filterkriterium z.B. unterschiedliche Echolaufzeiten verarbeiten, so können von einem Anwender unterschiedliche Schaltbereiche eingestellt werden. Es ist dann möglich, an einem Schaltausgang durch ein binäres Signal anzuzeigen, ob sich ein Gegenstand z.B. im selektierten Bereich befindet. Ist ein davon abweichender Schaltbereich eingestellt, so kann an dem Schaltausgang durch das binäre Signal auch angezeigt werden, ob sich ein Gegenstand z.B. im weiteren Erfassungsfenster befindet. Weist der jeweilige Ultraschallnäherungsschalter zwei oder mehr Schaltausgänge auf, so können auf diese Weise mehrere Entfernungsbereiche überwacht werden. Die binären Schaltsignale an dem einen bzw. den mehreren Schaltausgängen können schließlich einer speicherprogrammierbaren Steuerung zum Zwecke einer anwendungsspezifischen Weiterverarbeitung gemeldet werden.

Bislang ist es üblich, in einem Ultraschallnäherungsschalter für die Entscheidung, ob Schaltausgänge gesetzt bzw. rückgesetzt werden sollen Filterstufen mit einem einheitlichen Filterkriterium einzusetzen. Bei komplexeren Anwendungen können dabei aber Ungenauigkeiten auftreten. So kann das Sortieren und Zählen von Gegenständen mittels eines derart aufgebauten Ultraschallnäherungsschalters unzuverlässig sein. Insbesondere ist bei Anwendung nur einer Filterstufe mit einem einheitlichen Filterkriterium eine Erkennung der Bewegung von Objekten nicht ohne weiteres möglich. So ist z.B. keine Unterscheidung möglich, ob sich ein detektierter Gegenstand bewegt oder sich nur stationär im Bereich des Schallbündels eines Näherungsschalters befindet.

Derartige Anwendungen können z.B. in der Förder- oder Verkehrstechnik auftreten. So kann es in einem Anwendungsfall erforderlich sein, dass nicht nur die Belegung eines Förderbandes mit Gegenständen erkannt werden soll. Vielmehr soll auch eine Information darüber bereit stehen, ob sich das Förderband und damit der Gegenstand bewegen. Ähnliche Anwendungen können auch in der Verkehrstechnik auftreten. Etwa in Kreuzungsbereichen oder auf Gleisabschnitten ist nicht nur das Vorhandensein von Fahrzeugen zu erfassen. Vielmehr soll auch eine Information darüber bereit stehen, ob ein erfasstes Fahrzeug still steht oder noch bzw, schon in Bewegung ist.

Aus DE 198 31 978 A1 ist eine Sensorschaltung bekannt, die mehrere Schaltzustände darstellen kann. Hierbei wird ein Eingangssignal mit mehreren Schwellwerten verglichen, wobei beim Überschreiten beziehungsweise Unterschreiten der einzelnen Schwellwerte ein Ausgangssignal generiert wird, das eine Reihe von verschiedenen Schaltzuständen darstellen kann.

Der Erfindung liegt somit die Aufgabe zu Grunde, bekannte Näherungsschalter auf Ultraschallbasis derart weiter auszubilden, dass eine Signalisierung auch von Zuständen möglich ist, welche über das reine Erkennung des Vorhandenseins oder Fehlen eines Objektes an einem bestimmten Ort hinausgehen.

Die Aufgabe wird mit einem Ultraschallsensor gemäß Anspruch 1 gelöst. Vorteilhafte weitere Ausführungen der Erfindung sind in den Unteransprüchen angegeben.

Der erfindungsgemäße Ultraschallsensor weist eine akustische Abstrahlungs- und Empfangseinheit auf, welche zyklisch Ultraschallsendebursts emittiert, Messwerte der hiervon hervorgerufenen Ultraschallechosignale erfasst und diese einer elektronischen Verarbeitungseinheit zuführt. Die Verarbeitungsein-heit verwaltet erfindungsgemäß zumindest zwei separate Filterstufen mit jeweils mindestens einem eigenständigen Filterkriterium und vorgebbarem Schwellwert. Diesen Filterstufen führt die Verarbeitungseinheit zyklisch zumindest einen Messwert zu, welche bei einem Erreichen des jeweiligen Schwellwertes durch das Filterkriterium ein binäres Signal erzeugen. Hiermit wird von der Verarbeitungseinheit schließlich jeweils ein separater Schaltausgang des Ultraschallsensors aktiviert.

Der besondere Vorteil der Erfindung wird darin gesehen, dass die Messwerte durch die eigenständigen Filterkriterien in den einzelnen Filterstufen der empfangenen Ultraschallechosignale unterschiedlichen, insbesondere statistischen Auswerteverfahren unterzogen werden können. Es ist damit möglich, dynamische Vorgänge, d.h. auch bewegte Objekte erkennen zu können und differenzierter z.B. einer Steuerung zu melden.

Weist ein Ultraschallsensor zum Beispiel zwei Schaltausgänge auf, so können hiermit unterschiedliche Kombinationen von Binärsignalen ausgegeben und damit differenziertere Informationen z.B. an eine speicherprogrammierbare Steuerung übermittelt werden. So kann z.B. durch einen aktiven bzw. nicht aktiven ersten Schaltausgang angezeigt werden, ob der Ultraschallwandler ein Objekt erfasst hat oder nicht. Ist in diesem Falle der erste Schaltausgang aktiv, so kann durch einen aktiven bzw. nicht aktiven zweiten Schaltausgang zusätzlich angezeigt werden, ob das erfasste Objekt in Bewegung ist oder nicht. Dies stellt nur eines von vielen möglichen Beispielen dar, um mit Hilfe der erfindungsgemäßen Mehrfachauswertung der Messsignale im Ultraschallsensor mittels separaten Filterstufen mit eigenständigen Filterkriterien erweiterte Informationen ableiten zu können.

In der Praxis können z.B. in jedem Messzyklus eines erfindungsgemäßen Ultraschallnäherungsschalters die Istwerte von Amplitude und Laufzeit aller Empfangssignale aufgezeichnet werden. Den Empfangssignalen sind erfindungsgemäß separate, einzeln aktivier- und parametrierbare Filterstufen mit einstellbaren Filtertiefen zugeordnet. Die Filterstufen können somit für unterschiedliche Detektionsaufgaben optimiert eingestellt werden. Durch die erfindungsgemäß unabhängig voneinander arbeitenden parallelen Filterstufen können z.B. Stabilität und Amplitude von allen Empfangssignalen kontinuierlich verfolgt werden. Es ist somit möglich festzustellen, ob die vorliegenden Werte an Signalstabilität bzw. Signalamplitude vorgegebene Schwellwerte überschreiten und somit als gültig oder ungültig angesehen werden können. Diese Ergebnisse können dann in binäre Zustandssignale umgesetzt werden.

Mit den beispielhaften Filterkriterien Stabilität und Amplitude ist besonders vorteilhaft eine Erfassung z.B. von dynamischen Vorgängen möglich, besonders von Objektbewegungen. Die gewonnenen binären Zustandssignale zu den Filterkriterien Amplitude und Stabilität werden zwei voneinander unabhängigen Schaltausgängen zugeordnet. Vorteilhaft kann für die Erfassung von bewegten Objekten der erste Schaltausgang über eine Filterstufe mit dem Filterkriterium größte Echoamplitude und der zweite Schaltausgang über eine Filterstufe mit dem Filterkriterium stabilstes Echo angesteuert werden. Bei einer anderen Anwendung der Erfindung können mit einem Ultraschallnäherungsschalter, dessen zumindest zwei Schaltausgängen erfindungsgemäß von unterschiedlichen Filterstufen angesteuert werden, auch Informationen über Höhe bzw. Ausdehnung eines Objektes bzw. über die Art von dessen Oberfläche, d.h. insbesondere über Plan- bzw. Rauheit, gewonnen werden.

Die Erfindung wird nachfolgend an Hand der nachfolgend kurz angeführten Figuren näher erläutert. Dabei zeigt
- Fig. 1: Den Einsatz eines erfindungsgemäßen Ultraschallsensors am Beispiel einer Fördereinrichtung, und
- Fig. 2: einen Ablaufplan mit Funktionsblöcken für den Betrieb eines erfindungsgemäßen Ultraschallsensors mit zwei Filterstufen und diesen zugeordneten Schaltausgängen.

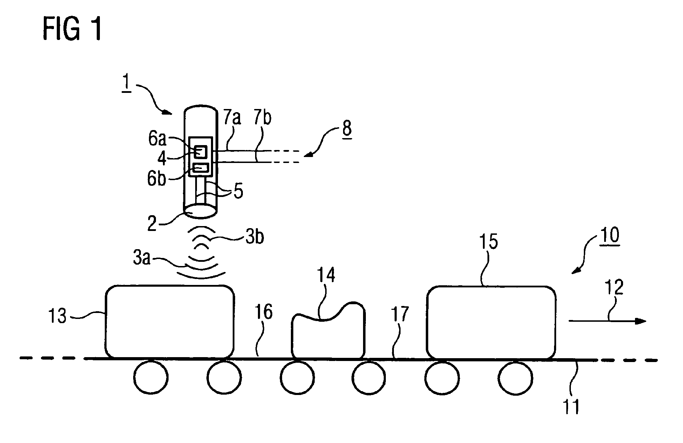

In Fig. 1 ist der Einsatz eines erfindungsgemäßen Ultraschallsensors 1 am Beispiel einer Fördereinrichtung 10 gezeigt. Diese weist ein Förderband 11 auf, das beispielhafte Gegenstände 13, 14 und 15, z.B. Frachtstücke, in einer Bewegungsrichtung 12 fördert. Mit Hilfe des erfindungsgemäßen Ultraschallsensors 1 sind verschiedene Auswertungen möglich. So kann zum einen erkannt werden, ob gerade einer der Gegenständen 13, 14 und 15 unter dem Sensor vorbeiläuft oder ob eine Lücken 16, 17 zwischen verschiedenen Gegenständen vorhanden ist. Auf Grund unterschiedlicher Filterstufen mit separaten Filterkriterien können u.U. auch die Abmessungen der einzelnen Gegenstände erfasst werden, z.B. deren Höhe und Länge. So können z.B. mit dem Filterkriterium "Stabilität" Kanten von Gegenständen, und damit deren Anfang und Ende erfasst werden. Bei bekannter Geschwindigkeit des Förderbandes 11 ist damit ohne weiteres eine Aussage über die jeweilige Länge eines Objektes möglich. Insbesondere kann mit separaten Filterstufen und dem Einsatz von geeigneten Filterkriterien auch erkannt werden, ob ein Gegenstand in Ruhe oder in Bewegung ist. Hierzu können z.B. Veränderungen in der Echostabilität ausgewertet, aber auch störende Mehrfachreflexionen von Echos an unterschiedlichen Objektflächen unterdrückt werden.

Der in Fig. 1 symbolisch dargestellte Ultraschallsensor 1 weist eine akustische Abstrahlungs- und Empfangseinheit 2 auf. Diese emittiert zyklisch Ultraschallsignale und empfängt die davon in der Umgebung hervorgerufenen Echos. Im Beispiel der Fig. 1 ist dies durch Keulen von Ultraschallsendebursts 3a bzw. Ultraschallechosignalen 3b symbolisiert.

Die akustische Abstrahlungs- und Empfangseinheit 2 ist über Leitungen 5 mit einer elektronischen Verarbeitungseinheit 4 verbunden. Diese sorgt einerseits für eine Zuführung von Ansteuerspannungen zur Erzeugung von Sendebursts bzw. andererseits für einen Abgriff von Messspannungen der Ultraschallechosignale an der Abstrahlungs- und Empfangseinheit 2. Gemäß der Erfindung werden in der elektronischen Verarbeitungseinheit 4 bevorzugt programmtechnisch verschiedene Filterstufen verwaltet, und die davon erzeugten Zustandsignale über einzelne Schaltausgänge des Ultraschallsensors 1 ausgegeben. In Fig. 1 sind hierzu symbolisch eine erste bzw. zweite Filterstufe 6a, 6b im Funktionsblock der Verarbeitungseinheit 4 dargestellt, und deren binären Ergebnisausgänge einem ersten bzw. zweiten Schaltausgang 7a, 7b zugeordnet. Diese können z.B. an eine Datenbusschnittstelle 8 gekoppelt sein. Auf diese Weise können die Zustände der Schaltausgänge des erfindungsgemäßen Ultraschallwandlers direkt oder durch Vermittlung über eine Datenbusschnittstelle 8 einer übergeordneten Verarbeitungseinheit, z.B. einer speicherprogrammierbaren Steuerung, einer weiteren Bearbeitung zugeführt werden.

In Fig. 1 können die Filterstufen 6a, 6b der Schaltausgänge 7a, 7b z.B. folgendermaßen ausgelegt sein:
- Optimierung des Filterkriteriums für die erste Filterstufe 6a am Schaltausgang 7a zur Erkennung eines Gegenstandes vom Typ 13 bzw. 15, d.h. Auswahl einer hohen Signalamplitude und einer hohen Verweildauer des Echosignals als optimierte Stabilitätskriterien.
- Optimierung des Filterkriteriums für die zweite Filterstufe 6b am Schaltausgang 7b zur Erkennung eines Gegenstandes vom Typ 14, d.h. Auswahl einer reduzierten Signalamplitude und einer kürzeren Verweildauer des Echosignals als optimierte Stabilitätskriterien.

Alternativ kann die zweite Filterstufe 6b auch folgendermaßen ausgelegt sein:
- Optimierung des Filterkriteriums für die Filterstufe 6b am Schaltausgang 7b zur Zählung von Gegenständen. Hierzu Auswahl einer stark reduzierten Signalamplitude besonders für ein zweites Echosignal in einer Kette von Messwerten und Auswahl einer kurzen Verweildauer des Echosignals als optimierte Stabilitätskriterien zur Erkennung von Lücken 16, 17 zwischen den Gegenständen 13, 14, 15.

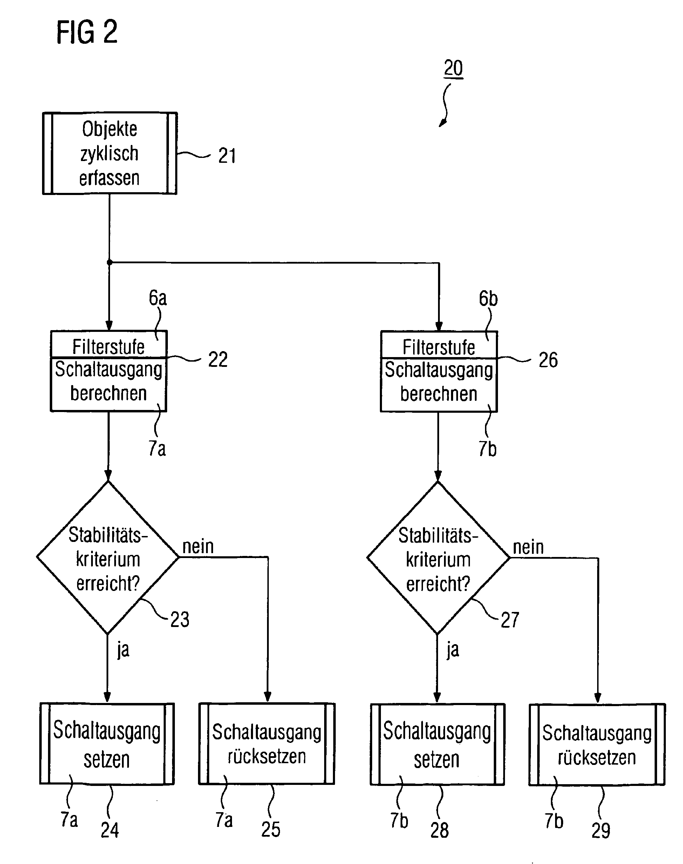

In Fig. 2 ist in Form eines Funktionsdiagramms ein beispielhafter Ablauf 20 einer Messsignalauswertung in der elektronischen Verarbeitungseinheit 4 eines erfindungsgemäßen Ultraschallsensors dargestellt. Dabei hat der Funktionsblock 21 zu Beginn die Aufgabe einer zyklischen Emission von Schallbündeln und einer entsprechenden Erfassung der davon hervorgerufenen Echosignale. Die Echosignale werden daraufhin als Messwerte zwei parallelen Ästen zugeführt, welche im Prinzip gleich aufgebaut sind. Dabei repräsentiert der Funktionsblock 22 bzw. 26 die Filterstufe 6a bzw. 6b. In diesem werden die Messwerte dem jeweils parametrierten Filterkriterium unterzogen. Mit dem folgenden Funktionsblock 23 bzw. 27 kann dann festgestellt werden, ob dabei der vorgegebene Schwellenwert für das jeweilige Stabilitätskriterium der Filterstufen 6a bzw. 6b erreicht wurde oder nicht. Abhängig vom jeweiligen Ergebnis wird dann der Schaltausgang 7a bzw. 7b entweder im Funktionsblock 24 bzw. 28 gesetzt, oder über den Funktionsblock 25 bzw. 29 wieder rückgesetzt.

Selbstverständlich ist die Erfindung nicht darauf beschränkt, dass ein Ultraschallsensor nur zwei Schaltausgänge mit nur zwei separaten Filterstufen aufweist. So können bereits mit zwei binären Schaltausgängen vier unterschiedliche Zustände signalisiert werden, also 0,0 bzw. 0,1 bzw. 1,0 oder 1,1. Bei einer entsprechenden Ausführung der Erfindung könnte also einem jeden dieser Zustände eine eigene Filterstufe mit einem eigenständig parametrierbaren Filterkriterium zugeordnet werden. Je größer die Anzahl der Schaltausgänge des Ultraschallsensors ist, umso mehr parallele Filterstufen mit unabhängigen Filterkriterien können für die Auswertung der Messsignale vorgesehen werden. Auf Grund der Erfindung ist es also möglich, mit Hilfe von Ultraschallsensoren Zustände zu erfassen, welche deutlich über die bisherige einfache Signalisierung des Vorhandenseins oder Fehlens eines Objektes an einer Messstelle hinausgehen.

## Patentansprüche

1. Ultraschallsensor (1) mit einer elektronischen Verarbeitungseinheit und mit einer akustischen Abstrahlungs- und Empfangseinheit (2), welche zyklisch Ultraschallsendebursts (3a) emittiert, Messwerte (5) der hiervon hervorgerufenen Ultraschallechosignale (3b) erfasst und diese der elektronischen Verarbeitungseinheit (4) zuführt, und der Ultraschallsensor (1) zumindest zwei separate Schaltausgänge (7a, 7b) aufweist, die von der Verarbeitungseinheit (4) ansteuerbar sind, wobei die Verarbeitungseinheit (4)
- zumindest zwei separate Filterstufen (6a, 6b) mit jeweils mindestens einem eigenständigen Filterkriterium und vorgebbarem Schwellwert verwaltet,
- zyklisch zumindest einen Messwert (5) den Filterstufen (6a, 6b) zuführt, welche bei einem Erreichen des jeweiligen Schwellwerts durch das Filterkriterium ein binäres Signal erzeugen und hiermit
- einen der zwei separaten Schaltausgänge (7a, 7b) aktivieren, wobei im Filterkriterium einer Filterstufe die Stabilität zumindest eines Messwerts (5) ausgewertet wird.

2. Ultraschallsensor nach Anspruch 1,
wobei im Filterkriterium einer Filterstufe (6a, 6b) die Amplitude zumindest eines Messwerts (5) ausgewertet wird.

3. Ultraschallsensor nach einem der vorangegangenen Ansprüche,
wobei von einer Filterstufe (6a, 6b) zusätzlich die Verweildauer der Erreichung des jeweiligen Filterkriteriums erfasst wird.

4. Ultraschallsensor nach einem der vorangegangenen Ansprüche,
wobei von einer Filterstufe (6a, 6b) eine Gruppe von Messwerten zur Bildung des Ist-Werts des jeweiligen Filterkriteriums herangezogen wird.

## Claims

1. An ultrasonic sensor (1) comprising an electronic processing unit and having an acoustic transceiver unit (2) adapted to emit cyclic ultrasonic transmission bursts (3a), to ascertain measured values (5) of the resulting therefrom ultrasonic echo signals (3b) and to feed said measured values to said electronic processing unit (4), which ultrasonic sensor (1) comprises at least two separate switching outputs (7a, 7b) capable of being activated by said processing unit (4), wherein said processing unit (4)
- controls at least two separate filter stages (6a, 6b) each having at least one independent filtering criterion and a configurable threshold value,
- cyclically feeds at least one measured value (5) to said filter stages (6a, 6b) which on reaching the respective threshold value produce a binary signal by way of the filtering criterion and by this means
- activate one of said two separate switching outputs (7a, 7b), wherein in the filtering criterion of a filter stage the stability of at least one measured value (5) is evaluated.

2. The ultrasonic sensor as defined in claim 1,
wherein the amplitude of at least one measured value (5) is evaluated in the filtering criterion of a filter stage (6a, 6b).

3. The ultrasonic sensor as defined in any one of the previous claims,
wherein the dwell time required to achieve the respective filtering criterion is additionally registered by a filter stage (6a, 6b).

4. The ultrasonic sensor as defined in any one of the previous claims,
wherein a group of measured values is taken into account by a filter stage (6a, 6b) for the formation of the actual value of the respective filtering criterion.

## Revendications

1. Capteur à ultrasons (1) avec une unité de traitement électronique et avec une unité de rayonnement acoustique et de réception (2), qui émet de manière cyclique des salves d'émissions d'ultrasons (3a), assure la prise en compte de valeurs de mesure (5) des signaux d'échos ultrasonores (3b) provoqués par celles-ci, et fournit ces dernières à l'unité de traitement électronique (4), le capteur à ultrasons (1) comprenant au moins deux sorties de commutation (7a, 7b) distinctes qui peuvent être commandées par l'unité de traitement (4), dans lequel l'unité de traitement (4) :
- gère au moins deux étages de filtrage distincts (6a, 6b), chacun d'eux ayant au moins un critère de filtrage indépendant et une valeur de seuil prédéfinie,
- fournit de façon cyclique au moins une valeur de mesure (5) aux étages de filtrage (6a, 6b), qui, lorsqu'une valeur de seuil respective est atteinte sur la base du critère de filtrage, produisent un signal binaire, et, au moyen de celui-ci,
- activent l'une des deux sorties de commutation (7a, 7b) distinctes, la stabilité d'au moins une valeur de mesure (5) étant évaluée dans le critère de filtrage d'un étage de filtrage.

2. Capteur à ultrasons selon la revendication 1,
dans lequel l'amplitude d'au moins une valeur de mesure (5) est évaluée dans le critère de filtrage d'un étage de filtrage (6a, 6b).

3. Capteur à ultrasons selon une des revendications précédentes,
dans lequel, en outre, il est procédé à la saisie de la durée de présence de la réalisation de chaque critère de filtrage par un étage de filtrage (6a, 6b).

4. Capteur à ultrasons selon une des revendications précédentes,
dans lequel, pour la formation de la première valeur de chaque critère de filtrage, un groupe de valeurs de mesure est mis à contribution par un étage de filtrage (6a, 6b).
